# EUROPÄISCHE PATENTSCHRIFT

(11) **EP 3 146 814 B1**
(45) Veröffentlichungstag und Bekanntmachung des Hinweises auf die Patenterteilung: **02.09.2020**
(21) Anmeldenummer: 15728377.1
(22) Anmeldetag: 19.05.2015
(51) Int. Cl.: H05K 7/14, H02G 11/02, G02B 6/44, H04Q 1/06

(54) **EINSCHUBELEMENT FÜR RAHMENGESTELLE**
INSERT ELEMENT FOR FRAMEWORKS
ÉLÉMENT RACKABLE POUR BAIES

(30) Priorität: 20.05.2014 AT 3802014
(43) Veröffentlichungstag der Anmeldung: 29.03.2017
(73) Patentinhaber: Patchbox GmbH, 1170 Wien (AT)
(72) Erfinder: GENG, Alexander, 1030 Wien (AT); HOFSTÄTTER, Josef, 3376 Ennsbach (AT)
(74) Vertreter: Keschmann, Marc
(86) Internationale Anmeldenummer: PCT/AT2015/000076
(87) Internationale Veröffentlichungsnummer: WO 2015/176086

(56) Entgegenhaltungen:
- US-A1- 2006 273 211
- US-A1- 2010 172 083
- US-B1- 6 483 033

## Beschreibung

Die Erfindung betrifft ein Einschubelement für Rahmengestelle, insbesondere Racks, zur Anwendung in der Informations- und Netzwerktechnik, umfassend eine Mehrzahl von Einschubplätzen. Die Erfindung betrifft weiters ein Kabelspeicherelement zum Einschieben in einen Einschubplatz des Einschubelements.

Die US 2010/172083 A1 offenbart ein Einschubelement für Rahmengestelle, insbesondere Racks, zur Anwendung in der Informations- und Netzwerktechnik, umfassend eine Mehrzahl von Einschubplätzen, wobei die Einschubplätze einschiebbare Kabelspeicherelemente aufnehmen, in denen jeweils ein Kabel aufgenommen ist, dessen Kabelende über an der Stirnseite des Kabelspeicherelements ausgebildete Öffnungen nach außen geführt und längenveränderlich aus dem Kabelspeicherelement herausziehbar sind.

Das US 6 483 033 B1 zeigt ein Kabelmanagementsystem für elektronische Patch- und Routing-Systeme.

Die US 2006/273211 A1 offenbart ein Kabelspeicherelement, das ein längliches, einen quaderförmigen Speicherraum umschließendes Gehäuse umfasst, wobei im Speicherraum ein Kabel aufgenommen ist, dessen zwei Kabelenden über an gegenüberliegenden Seiten des Kabelspeicherelements ausgebildete Öffnungen nach außen geführt und längenveränderlich aus dem Kabelspeicherelement herausziehbar sind oder an der Stirnseite des Kabelspeicherelements nach außen geführt werden.

In der Informations- und Netzwerktechnik ist es oftmals nötig eine Vielzahl an Netzwerkkomponenten und Rechnern innerhalb eines Racks zu verstauen und diese über Kabel, insbesondere Netzwerkkabel miteinander zu verbinden. Im Rechenzentrumsbetrieb, aber auch in der Veranstaltungs-, Labor- und Regeltechnik steht der Begriff Rack für ein Gestell für Elektrogeräte mit einer genormten Breite von 48,26cm (19"), bei dem die einzelnen Geräte (sog. Einschubelemente), die sich im Rack montieren lassen, eine Frontplattenbreite von genau 48,26cm (19") aufweisen. Befestigt werden die Einschubelemente mit je vier Schrauben in den Lochreihen senkrecht laufender Blechwinkel nahe den Vorderkanten des Racks.

Die Verkabelung der einzelnen Einschubelemente untereinander gestaltet sich aufwändig. Werden Kabel mit Standard-Kabellängen verwendet, besteht dass Problem, dass oftmals eine Überlänge vorhanden ist, die eine große Unordentlichkeit zur Folge hat, die weiters eine Unübersichtlichkeit und schwere Handhabbarkeit beim Umstecken der verschiedenen Kabel des Netzwerksystems bedingt.

Die vorliegende Erfindung zielt daher darauf ab, die vorgenannten Nachteile zu vermeiden.

Die Erfindung ist durch die unabhängigen Ansprüche definiert. Weitere Ausführungsformen der Erfindung sind in den abhängigen Ansprüchen dargelegt. Ausführungsformen, die nicht von den Ansprüchen abgedeckt werden, sind als Beispiele anzusehen, welche dem besseren Verständnis der Erfindung dienen.

Zur Lösung dieser Aufgabe umfasst das erfindungsgemäße Einschubelement für Rahmengestelle, insbesondere Racks, zur Anwendung in der Informations- und Netzwerktechnik, eine Mehrzahl von Einschubplätzen, wobei die Einschubplätze einschiebbare Kabelspeicherelemente aufnehmen, in denen jeweils ein Kabel aufgenommen ist, dessen zwei Kabelenden über an der Stirnseite des Kabelspeicherelements ausgebildete Öffnungen nach außen geführt und längenveränderlich aus dem Kabelspeicherelement herausziehbar sind. Dies gewährleistet eine ordentliche und platzsparende Aufbewahrung der Kabel innerhalb des Racks und eine Variabilität betreffend die Länge der jeweils erforderlichen Kabelverbindungen. Dadurch, dass beide Kabelenden an der Stirnseite des Kabelspeicherelements längenveränderlich herausgeführt werden können, kann die jeweils erforderliche Kabellänge aus dem Kabelspeicher herausgezogen werden, sodass sowohl die Verbindung zwischen zwei nahe zueinander befindlichen Einschubelementen bzw. Komponenten, als auch von im Rack weiter entfernt voneinander eingesteckten Einschubelementen bzw. Komponenten möglich ist. Störende Kabelüberlängen werden dabei vermieden.

Besonders vorteilhaft ist es, wenn die beiden Kabelenden unabhängig voneinander aus dem Kabelspeicher herausziehbar sind.

Das erfindungsgemäße Einschubelement ist daher dahingehend weitergebildet, dass die beiden Kabelenden jeweils unabhängig voneinander gegen eine Federkraft aus dem Kabelspeicherelement herausziehbar sind. Muss also nur eines der Kabelenden innerhalb des Racks umgesteckt werden ist dies möglich ohne die Verbindungen am anderen Kabelende lösen zu müssen. Dies hilft kompliziertes Umstecken und Umarrangieren der Kabelverbindungen zu vermeiden. Insbesondere wird dadurch vermieden, dass ein Kabel einer definierten Länge gegen ein kürzeres oder längeres Kabel getauscht werden muss.

Gemäß einer weiteren erfindungsgemäßen Ausführungsform ist das Einschubelement für Rahmengestelle derart ausgebildet, dass es eine Mehrzahl von Einschubplätzen umfasst, die einschiebbare Kabelspeicherelemente aufnehmen, in denen jeweils ein Kabel aufgenommen ist, dessen erstes Kabelende über eine an der einen Stirnseite des Kabelspeicherelements ausgebildete Öffnung nach außen geführt und längenveränderlich aus dem Kabelspeicherelement herausziehbar ist und dessen zweites Kabelende über eine an der zweiten, gegenüberliegenden Stirnseite des Kabelspeicherelements ausgebildete Öffnung nach außen geführt ist.

Diese erfindungsgemäße Ausführungsform bedingt eine wesentliche Platzersparnis innerhalb des Serverschrankes, da das an jener Stirnseite, die der Rückwand des Serverschrankes näher ist, das Kabelspeicherelement verlassende Kabelende fix mit einem auf der Innenseite der Rückwand des Serverschrankes befindlichen Patchfeld verbunden werden kann und demgemäß kein separates Patchfeld in einem weiteren Einschubplatz des Einschubelements benötigt wird.

Weiters kann dadurch ein wesentlich längeres Kabel im Kabelspeicherelement aufgenommen werden, da das Kabel bei dieser Ausführungsform ein weiteres Mal, d.h. insgesamt zwei Mal, um ein im Kabelspeicherelement befindliches Umlenkelement herumgeführt werden kann.

Erfindungsgemäß ist das vorgenannte Einschubelement dahingehend weitergebildet, dass das eine Kabelende unabhängig vom zweiten Kabelende gegen eine Federkraft aus dem Kabelspeicherelement herausziehbar ist.

Das freibewegliche Kabelende kann somit innerhalb des Racks umgesteckt werden ohne die Verbindungen am anderen Kabelende lösen zu müssen. Dies hilft kompliziertes Umstecken und Umarrangieren der Kabelverbindungen zu vermeiden. Insbesondere wird dadurch vermieden, dass ein Kabel einer definierten Länge gegen ein kürzeres oder längeres Kabel getauscht werden muss.

Das erfindungsgemäße Einschubelement ist dahingehend weitergebildet, dass das Kabel im Kabelspeicherelement um wenigstens eine gegen die Kraft eines Federelements verlagerbare, bevorzugt an dem Federelement befestigte Rolle geführt ist. Durch das Federelement wird das im Kabelspeicherelement aufgenommene Kabel auf Zug gehalten. Um die an dem Federelement befestige Rolle wird das aufzunehmende Kabel herumgeführt und aufgrund des Federelements kann die Rolle mittels Ziehen an den jeweiligen Kabelenden innerhalb des Kabelspeicherelements in Richtung der Stirnseite des Kabelspeicherelements bewegt werden und wird mittels der durch das Federelement auf die Rolle ausgeübten Federkraft nach Lösen der Kabelverbindung auch wieder in das Kabelspeicherelement zurückgezogen. Das Federelement kann beispielsweise als Schraubenfeder, Torsionsfeder, Biegefeder, z.B. Spiralblattfeder oder dergleichen ausgebildet sein.

Das erfindungsgemäße Einschubelement ist weiters dahingehend weitergebildet, dass das Kabel am der Rolle gegenüberliegenden Ende um ein Umlenkelement herum geführt ist, wobei das Umlenkelement bevorzugt als feststehendes Element, insbesondere als feststehende Rolle, ausgebildet ist. Durch das zweimalige Herumführen des Kabels um die Rolle sowie das Umlenkelement kann eine große Menge Kabel in einem vergleichsweise kleinen Speicherelement untergebracht werden und das Federelement ermöglicht ein variables Heraus- und wieder Hineinziehen eines oder beider Kabelenden. Das Umlenkelement erfüllt also eine doppelte Funktion. Einerseits dient es dazu das im Kabelspeicherelement aufzunehmende Kabel umzulenken - also um das Umlenkelement herumzuführen und andererseits dazu das obere und das untere Ende des Kabels jeweils ober- bzw. unterhalb des Umlenkelements aus dem Kabelspeicherelement herauszuführen. Das Umlenkelement ist bevorzugt drehbar gelagert.

Das erfindungsgemäße Einschubelement ist bevorzugt dahingehend weitergebildet, dass das Kabelspeicherelement ein einen quaderförmigen Speicherraum umschließendes Gehäuse umfasst und das Kabel im Speicherraum aufgenommen ist. Aufgrund dessen, dass sowohl das Einschubelement als auch das Kabelspeicherelement quaderförmig ausgebildet sind, wird eine höchst platzsparende und gleichzeitig den Platz innerhalb des Einschubelements bestmöglich ausnützende Aufbewahrungsmöglichkeit für die jeweiligen Kabel geschaffen.

In vorteilhafter Weise ist das erfindungsgemäße Einschubelement dahingehend weitergebildet, dass das Einschubelement eine Höhe von 4,445cm (1,75") oder 8,89cm (3,5") und eine Breite von 48,26cm (19") aufweist. Diese Dimensionen entsprechen den in einem handelsüblichen Rack vorhandenen Steckplätzen, was eine problemlose Aufnahme der erfindungsgemäß vorgesehenen Einschubelemente in bereits vorhandene Racks ermöglicht. Das erfindungsgemäße Einschubelement bedarf also keines eigens dafür angefertigten Racks.

Das erfindungsgemäße Einschubelement kann insbesondere dahingehend weitergebildet sein, dass das Einschubelement wenigstens 3, vorzugsweise 5 bis 48, insbesondere 24 Einschubplätze aufweist. Hierbei kommt es jeweils auf die Dicke bzw. die Länge der aufzunehmenden Kabel an. Bei dünnen, kurzen Kabeln kann das Kabelspeicherelement weniger breit ausgebildet sein, was bedingt, dass ein Einschubelement auch eine größere Anzahl an Einschubplätzen besitzen kann. Bei dickeren, längeren Kabeln sind breitere Kabelspeicherelemente vonnöten, was wiederum Einschubelemente bedingt, die weniger Einschubplätze besitzen. Weiters ist auch eine Kombination von verschieden breiten Einschubplätzen innerhalb eines Einschubelements denkbar.

Das erfindungsgemäße Einschubelement ist dahingehend weitergebildet, dass die gegen die Kraft des Federelements verlagerbare, insbesondere am Federelement befestigte Rolle wenigstens ein bevorzugt mittig der Rolle angeordnetes Trennelement aufweist. Das Trennelement fungiert hierbei als Trennwand zwischen den um die Rolle geführten Kabelabschnitten. Dies ermöglicht ein problemsloses Hinein- und Hinausziehen der Kabelenden, da sich die unterschiedlichen Kabelabschnitte aufgrund des Trennelements nicht überschneiden können.

In vorteilhafter Weise ist das erfindungsgemäße Einschubelement dahingehend weitergebildet, dass Mittel zum Bremsen der Rückstellbewegung der Rolle vorgesehen sind. Weiters kann das erfindungsgemäße Einschubelement insbesondere dahingehend weitergebildet sein, dass die Rolle schleifend mit der Gehäusewand des Speicherraums des Kabelspeicherelements zusammenwirkt. Die Höhe des Trennelements kann also beispielsweise derart gewählt sein, dass der erzielte Durchmesser der Rolle die Höhe des Gehäuses des Kabelspeicherelements nur geringfügig unterschreitet, wodurch die Rolle beim Loslassen eines der Kabelenden aufgrund der Federkraft langsam zurückläuft und somit ein unkontrolliertes und ruckartiges Einziehen des Kabels vermieden wird.

Weiters kann bevorzugt vorgesehen sein, dass das Kabelspeicherelement ein Rollensystem mit mehreren, insbesondere zwei federnd gehaltenen Rollen umfasst. Dies erleichtert es die zwei federnd gehaltenen Rollen samt den diesen umgebenden Kabeln unabhängig voneinander heraus ziehen zu können.

Besonders bevorzugt ist das erfindungsgemäße Einschubelement dahingehend weitergebildet, dass zwischen jeweils zwei federnd gehaltenen Rollen des Rollensystems eine Trennwand angebracht ist. Das erfindungsgemäße Einschubelement ist hierbei bevorzugt dahingehend weitergebildet, dass die Trennwand den Speicherraum in zwei Kammern unterteilt und die erste federnd gehaltene Rolle in der ersten Kammer geführt ist und die zweite federnd gehaltene Rolle in der zweiten Kammer geführt ist. Hierdurch wird ein störungsfreies Bewegen der jeweiligen Rolle ermöglicht ohne dass diese von der jeweils anderen Rolle behindert wird.

Das erfindungsgemäße Einschubelement kann insbesondere dahingehend weitergebildet sein, dass das Kabel ein Flachbandkabel, insbesondere ein Koaxialkabel bzw. ein Twisted-Pair Kabel oder ein rundes Kabel ist. Das Kabel kann weiters ein Netzwerkabel, ein Audiokabel, ein Glasfaserkabel oder ein Telefonkabel sein.

In vorteilhafter Weise ist das erfindungsgemäße Einschubelement dahingehend weitergebildet, dass das Kabelspeicherelement bis zu 2,4m Kabel aufnehmen kann. Die Aufnahme von 2,4m Kabel ist insbesondere bei einem Kabelspeicherelement mit einer Tiefe von 60cm möglich. Analog kann ein Kabelspeicherelement mit einer Tiefe von 30cm 1,2m Kabel, ein Kabelspeicherelement mit einer Tiefe von 100cm 4m Kabel und ein Kabelspeicherelement mit einer Tiefe von 120cm 4,8m Kabel aufnehmen.

Die Erfindung betrifft weiters ein Kabelspeicherelement zum Einschieben in einen Einschubplatz eines Einschubelements, das ein längliches, einen quaderförmigen Speicherraum umschließendes Gehäuse umfasst, wobei im Speicherraum ein Kabel aufgenommen ist, dessen zwei Kabelenden über an der Stirnseite des Kabelspeicherelements ausgebildete Öffnungen nach außen geführt und längenveränderlich aus dem Kabelspeicherelement herausziehbar sind. Eine alternative Ausführungsform sieht hierbei vor dass das erste Kabelende über eine an der einen Stirnseite des Kabelspeicherelements ausgebildete Öffnung nach außen geführt und längenveränderlich aus dem Kabelspeicherelement herausziehbar ist und das zweite Kabelende über eine an der zweiten, gegenüberliegenden Stirnseite des Kabelspeicherelements ausgebildete Öffnung nach außen geführt ist.

Bevorzugte Weiterbildungen des Kabelspeicherelements gehen aus den Unteransprüchen hervor und wurden bereits in Zusammenhang mit dem erfindungsgemäßen Einschubelement erörtert.

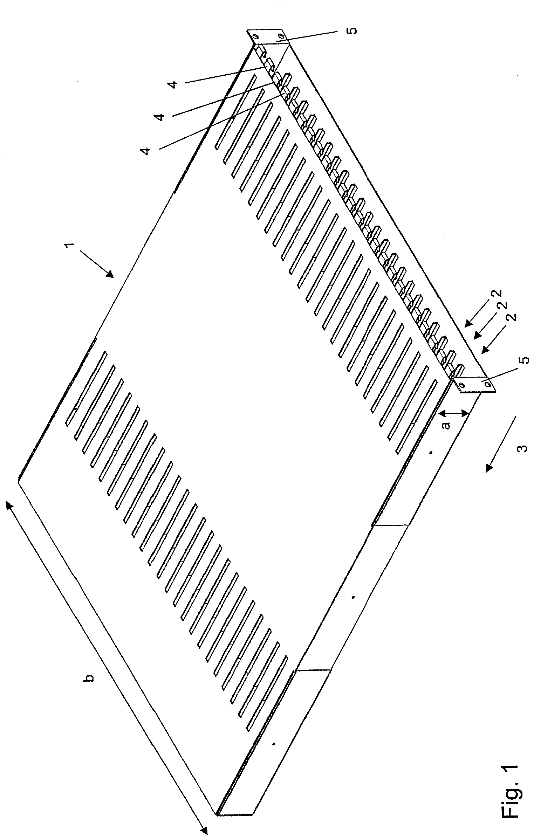

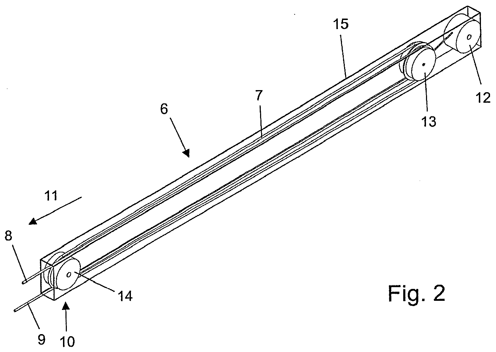

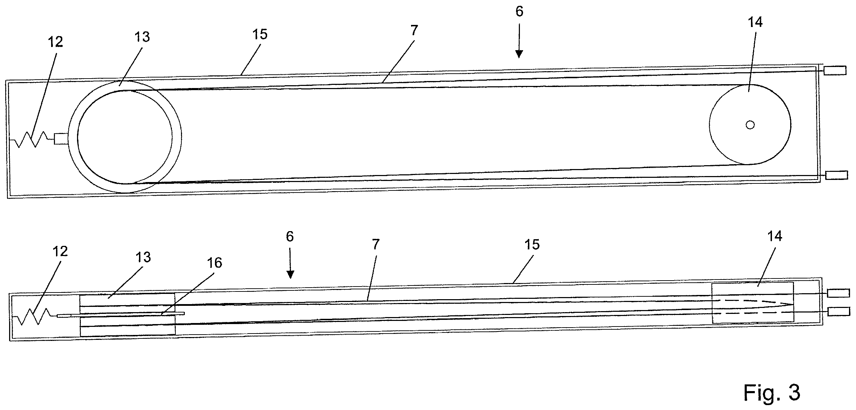

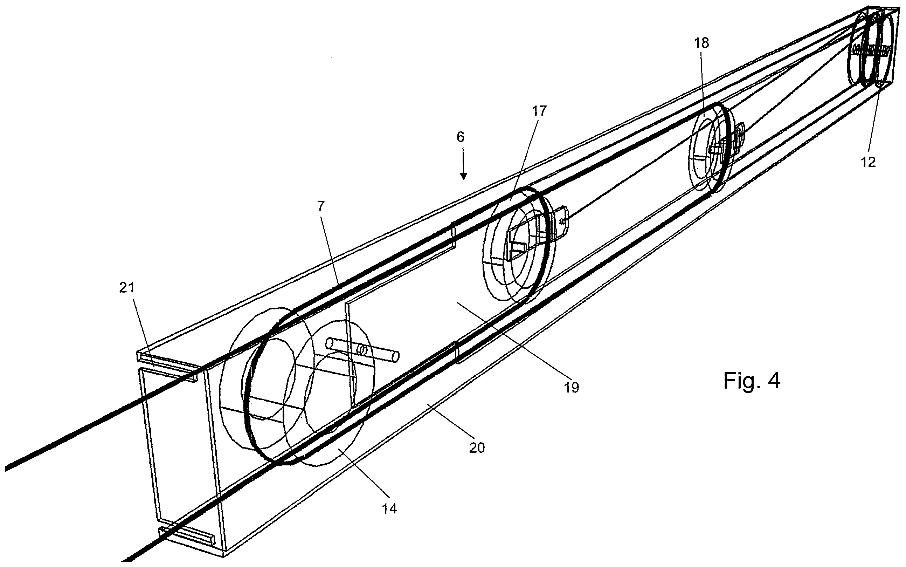

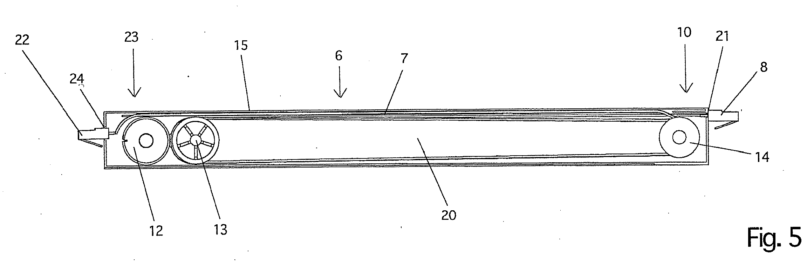

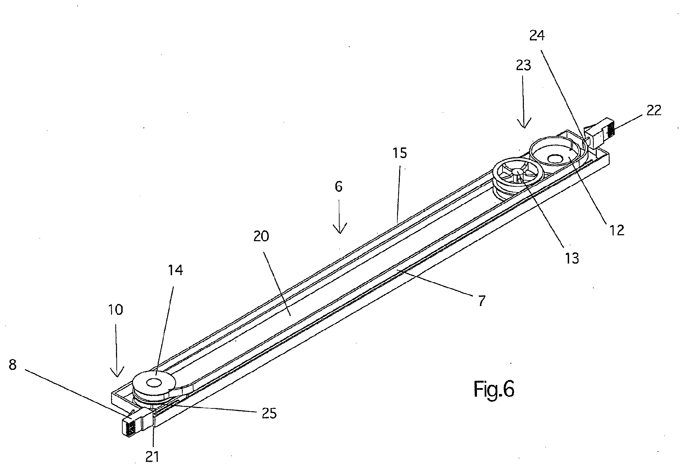

Die Erfindung wird nachfolgend anhand von in der Zeichnung schematisch dargestellten Ausführungsbeispielen näher erläutert. In dieser zeigt Fig.1 das erfindungsgemäße Einschubelement, Fig.2 eine erste Ausführungsform des Kabelspeicherelements gemäß der vorliegenden Erfindung, Fig.3 eine Draufsicht gemäß der ersten Ausführungsform des Kabelspeicherelements aus Fig.2, Fig.4 eine zweite Ausführungsform des Kabelspeicherelements gemäß der vorliegenden Erfindung, Fig. 5 die erfindungsgemäße Ausbildung des Kabelspeicherelements gemäß einem weiteren Aspekt der vorliegenden Erfindung und Fig.6 eine perspektivische Ansicht des in Fig.5 gezeigten Kabelspeichelements mit offenem Gehäuse.

Fig.1 zeigt ein Einschubelement 1 für Rahmengestelle, das 24 nebeneinander angeordnete Einschubplätze 2 zur Aufnahme von in die Einschubplätze 2 einschiebbaren Kabelspeicherelementen aufweist. Die einzelnen Einschubplätze sind jeweils durch in Längsrichtung verlaufende Führungselemente, insbesondere Trennstege voneinander getrennt. Das Einschubelement weist ein quaderförmiges Gehäuse mit einer bevorzugten Höhe a von 4,445cm (1,75") oder 8,89cm (3,5") und einer bevorzugten Breite b von 48,26cm (19") auf.

Die Kabelspeicherelemente werden in Richtung des Pfeils 3 in die Einschubplätze 2 des Einschubelements 1 eingeschoben und mittels Einrasten der Clips 4 am kopfseitigen Ende des Kabelspeicherelements im Einschubelement 1 fixiert. Mittels der seitlich an beiden Seiten des Einschubelements 1 angebrachten Verbindungselemente 5 kann das Einschubelement 1 mit dem Rahmengestell verschraubt werden.

In Fig.2 ist eine erste Ausführungsform eines erfindungsgemäßen Kabelspeicherelements 6 gezeigt, das in das in Fig.1 gezeigte Einschubelement einschiebbar ist. Das Kabelspeicherelement 6 weist ein quaderförmiges Gehäuse 15 auf, dessen Breite und Höhe im Wesentlichen der Breite und Höhe der Einschubplätze 2 entsprechen. Das Gehäuse nimmt hierbei ein Kabel 7 auf, dessen zwei Kabelenden 8, 9 über an der Stirnseite 10 des Kabelspeicherelements 6 ausgebildete Öffnungen (hier nicht abgebildet) in Richtung des Pfeils 11 nach außen geführt und längenveränderlich aus dem Kabelspeicherelement 6 herausziehbar sind. Denkbar wäre beispielsweise, dass die Öffnungen beiderseits eng zulaufen und die Kabel nach dem Herausziehen in den seitlich engeren Bereichen der Öffnungen eingeklemmt und somit fixiert werden können.

Weiters ist aus Fig.2 ersichtlich, dass das Kabelspeicherelement 6 ein Federelement 12, eine am Federelement 12 befestigte Rolle 13, sowie ein rollenförmiges Umlenkelement 14 besitzt. Das im Kabelspeicherelement 6 aufgenommene Kabel 7 ist um die am Federelement 12 befestigte Rolle 13 geführt und weiters am dem Federelement 12 gegenüberliegenden Ende um das Umlenkelement 14 herumgeführt. Das Kabel 7 wird hierbei an der Stirnseite 10 des Kabelspeicherelements 6 in das quaderförmiges Gehäuse 15 eingeführt, in Richtung der Rolle 13 geführt, ein erstes Mal um die Rolle 13 geführt und um 180° umgelenkt. Im Anschluss daran wird das Kabel 7 an die Stirnseite 10 des Kabelspeicherelements 6 zurückgeführt, wo es um das Umlenkelement 14 geführt wird, erneut um 180° umgelenkt wird und dann ein zweites Mal in Richtung der Rolle 13 geführt wird. Dort wird das Kabel 7 ein weiteres Mal um die Rolle 13 geführt, um 180° umgelenkt und erneut an die Stirnseite 10 des Kabelspeicherelements 6 zurückgeführt, wo es das quaderförmige Gehäuse 15 verlässt.

Durch Zug an den beiden Kabelenden 8, 9 gemäß Pfeil 11 können die Kabelenden 8, 9 jeweils unabhängig voneinander gegen die vom Federelement 12 ausgeübte Federkraft aus dem Kabelspeicherelement 6 herausgezogen werden.

Das Kabel 7 ist also sowohl um die Rolle 13 als auch um das Umlenkelement 14 herumgeführt, wodurch ermöglicht wird, dass die doppelte Menge an Kabel 7 im Kabelspeicherelement 6 aufgenommen werden kann.

Weiters wäre es denkbar, dass das Kabel mehr als zweimal um die Rolle 13 und das Umlenkelement 14 herumgeführt ist, was die Verstauung längerer Kabel 7 im Kabelspeicherelement 6 ermöglicht.

Fig.3 zeigt eine Draufsicht gemäß der ersten Ausführungsform des Kabelspeicherelements 6 aus Fig. 2. Die am Federelement 12 befestigte Rolle 13 besitzt ein mittig der Rolle 13 angeordnetes Trennelement 16, welches erstens dazu dient das Kabel 7 auch nach dem Umwickeln der Rolle 13 geordnet zu führen und zweitens als Mittel zum Bremsen der Rückstellbewegung der Rolle 13 fungiert, da die Höhe des Trennelements 16 derart gewählt ist, dass das Trennelement 16 schleifend mit der Gehäusewand 15 des Speicherraums des Kabelspeicherelements 6 zusammenwirkt.

In Fig. 4 ist anhand einer weiteren Ausführungsform der vorliegenden Erfindung gezeigt, dass das Einschubelement 6 ein Rollensystem mit zwei federnd gehaltenen Rollen 17, 18 umfassen kann. Hierbei ist zwischen den zwei federnd gehaltenen Rollen 17, 18 des Rollensystems eine Trennwand 19 angebracht. Die Trennwand 19 unterteilt den Speicherraum 20 in zwei Kammern, wobei die erste federnd gehaltene Rolle 17 in der ersten Kammer geführt und die zweite federnd gehaltene Rolle 18 in der zweiten Kammer geführt ist.

Weiters sind in Fig.4 die in Fig.2 nicht abgebildeten Öffnungen 21 gezeigt, über welche das Kabel 7 den Speicherraum 20 des Kabelspeicherelements 6 ober- und unterhalb des Umlenkelements 14 verlässt.

Eine weitere Ausführungsform, die sich von der zuvor beschriebenen Ausführungsform lediglich dadurch unterscheidet, dass das erste Kabelende des sich im Kabelspeicherelement befindlichen Kabels an der einen Stirnseite des Kabelspeicherelements längenveränderlich nach außen geführt ist und das zweite Kabelende an der zweiten Stirnseite des Kabelspeicherelements nach außen geführt ist, ist in den Fig.5 und 6 gezeigt. Ansonsten weisen die beiden Ausführungsformen keine wesentlichen konstruktiven Unterschiede auf und die Bezugszeichen wurden weitestgehend beibehalten.

In Fig.5 ist ein Kabelspeicherelement 6 gezeigt, das ein längliches, einen quaderförmigen Speicherraum 20 umschließendes Gehäuse 15 umfasst, wobei im Speicherraum 20 ein Kabel 7 aufgenommen ist, dessen erstes Kabelende 8 über eine an der ersten Stirnseite 10 des Kabelspeicherelements 6 ausgebildete Öffnung 21 nach außen geführt und längenveränderlich aus dem Kabelspeicherelement 6 herausziehbar ist und dessen zweites Kabelende 22 über eine an der zweiten Stirnseite 23 des Kabelspeicherelements 6 ausgebildete Öffnung 24 nach außen geführt ist. Das Kabelende 22 wird in weiterer Folge fix, d.h. in seiner Länge nicht veränderbar, mit einem auf der Innenseite der Rückwand des Serverschrankes befindlichen Patchfeld (nicht gezeigt) verbunden.

Weiters ist Fig.5 zu entnehmen, dass das Kabel 7 im Speicherraum 20 zwei Mal um die am Federelement 12 befestigte Rolle und zwei Mal um das Umlenkelement 14 geführt ist. Das im Kabelspeicherelement 6 aufgenommene Kabel 7 ist um die am Federelement 12 befestigte Rolle 13 geführt und weiters am dem Federelement 12 gegenüberliegenden Ende um das Umlenkelement 14 herumgeführt. Das Kabel 7 wird hierbei an der Stirnseite 10 des Kabelspeicherelements 6 in das Kabelspeicherelement 6 eingeführt, in Richtung der Rolle 13 geführt, ein erstes Mal um die Rolle 13 geführt und um 180° umgelenkt. Im Anschluss daran wird das Kabel 7 an die Stirnseite 10 des Kabelspeicherelements 6 zurückgeführt, wo es um das Umlenkelement 14 geführt wird, erneut um 180° umgelenkt wird und dann ein zweites Mal in Richtung der Rolle 13 geführt wird. Dort wird das Kabel 7 ein weiteres Mal um die Rolle 13 geführt, um 180° umgelenkt und erneut an die Stirnseite 10 des Kabelspeicherelements 6 zurückgeführt, wo es erneut um das Umlenkelement 14 geführt wird und ein drittes Mal in Richtung der Rolle 13 geführt wird, wo es das Kabelspeicherelement 6 schließlich über die an der zweiten Stirnseite 23 des Kabelspeicherelements 6 ausgebildete Öffnung 24 verlässt.

Fig.6 zeigt eine perspektivische Ansicht des in Fig.5 gezeigten Kabelspeichelements mit offenem Gehäuse. Weil das Kabel 7 - wie zuvor erwähnt - zwei Mal um das Umlenkelement 14 geführt wird, weist dieses ein mittig am Umlenkelement 14 angeordnetes Trennelement 25 auf, das als Trennwand zwischen den um das Umlenkelement 14 geführten Kabelabschnitten dient. Dies ermöglicht ein problemloses Hinein- und Hinausziehen des Kabelendes 8, da sich die unterschiedlichen Kabelabschnitte aufgrund des Trennelements nicht überschneiden können.

## Patentansprüche

1. Einschubelement für Rahmengestelle, insbesondere Racks, zur Anwendung in der Informations- und Netzwerktechnik, umfassend eine Mehrzahl von Einschubplätzen und in die Einschubplätze (2) einschiebbare Kabelspeicherelemente (6), die in den Einschubplätzen (2) aufgenommen sind, **dadurch gekennzeichnet, dass** in den Kabelspeicherelementen (6) jeweils ein Kabel (7) aufgenommen ist, dessen zwei Kabelenden (8,9) über an der Stirnseite (10) des Kabelspeicherelements (6) ausgebildete Öffnungen (21) nach außen geführt und längenveränderlich aus dem Kabelspeicherelement (6) herausziehbar sind, wobei das Kabel (7) im Kabelspeicherelement (6) um wenigstens eine gegen die Kraft eines Federelements (12) verlagerbare, bevorzugt an dem Federelement befestigte Rolle (13) geführt ist und an dem der Rolle (13) gegenüberliegenden Ende um ein Umlenkelement (14) herum geführt ist, wobei das Umlenkelement (14) bevorzugt als feststehendes Element, insbesondere als feststehende Rolle, ausgebildet ist und die beiden Kabelenden (8,9) jeweils unabhängig voneinander gegen eine Federkraft aus dem Kabelspeicherelement (6) herausziehbar sind, wobei die gegen die Kraft des Federelements (12) verlagerbare, insbesondere am Federelement (12) befestigte Rolle (13) wenigstens ein Trennelement (16) aufweist, welches als Trennwand zwischen um die Rolle (13) geführten Kabelabschnitten fungiert und bevorzugt mittig der Rolle (13) angeordnet ist.

2. Einschubelement für Rahmengestelle, insbesondere Racks, zur Anwendung in der Informations- und Netzwerktechnik, umfassend eine Mehrzahl von Einschubplätzen und in die Einschubplätze (2) einschiebbare Kabelspeicherelemente (6), die in den Einschubplätzen (2) aufgenommen sind, **dadurch gekennzeichnet, dass** in den Kabelspeicherelementen (6) jeweils ein Kabel (7) aufgenommen ist, dessen erstes Kabelende (8) über eine an der einen Stirnseite (10) des Kabelspeicherelements (6) ausgebildete Öffnung (21) nach außen geführt und längenveränderlich aus dem Kabelspeicherelement (6) herausziehbar ist und dessen zweites Kabelende (22) über eine an der zweiten, gegenüberliegenden Stirnseite (23) des Kabelspeicherelements (6) ausgebildete Öffnung (24) nach außen geführt ist, wobei das Kabel (7) im Kabelspeicherelement (6) um wenigstens eine gegen die Kraft eines Federelements (12) verlagerbare, bevorzugt an dem Federelement befestigte Rolle (13) geführt ist und an dem der Rolle (13) gegenüberliegenden Ende um ein Umlenkelement (14) herum geführt ist, wobei das Umlenkelement (14) bevorzugt als feststehendes Element, insbesondere als feststehende Rolle, ausgebildet ist und die beiden Kabelenden (8,22) jeweils unabhängig voneinander gegen eine Federkraft aus dem Kabelspeicherelement (6) herausziehbar sind, wobei die gegen die Kraft des Federelements (12) verlagerbare, insbesondere am Federelement (12) befestigte Rolle (13) wenigstens ein Trennelement (16) aufweist, welches als Trennwand zwischen um die Rolle (13) geführten Kabelabschnitten fungiert und bevorzugt mittig der Rolle (13) angeordnet ist.

3. Einschubelement nach Anspruch 2, **dadurch gekennzeichnet, dass** das eine Kabelende (8) unabhängig vom zweiten Kabelende (22) gegen eine Federkraft aus dem Kabelspeicherelement (6) herausziehbar ist.

4. Einschubelement nach Anspruch 1, 2 oder 3, **dadurch gekennzeichnet, dass** das Kabelspeicherelement (6) ein einen quaderförmigen Speicherraum (20) umschließendes Gehäuse (15) umfasst und das Kabel (7) im Speicherraum (20) aufgenommen ist.

5. Einschubelement nach einem der Ansprüche 1 bis 4, **dadurch gekennzeichnet, dass** Mittel zum Bremsen einer Rückstellbewegung der Rolle (13) vorgesehen sind.

6. Einschubelement nach Anspruch 4 oder 5, **dadurch gekennzeichnet, dass** die Rolle (13) schleifend mit einer Gehäusewand des Speicherraums (20) des Kabelspeicherelements (6) zusammenwirkt.

7. Einschubelement nach einem der Ansprüche 1 bis 6, **dadurch gekennzeichnet, dass** das Kabelspeicherelement (6) ein Rollensystem mit mehreren, insbesondere zwei federnd gehaltenen Rollen (17,18) umfasst, wobei bevorzugt zwischen jeweils zwei federnd gehaltenen Rollen (17,18) des Rollensystems eine Trennwand (19) angebracht ist.

8. Einschubelement nach Anspruch 7, **dadurch gekennzeichnet, dass** die Trennwand (19) den Speicherraum (20) in zwei Kammern unterteilt und die erste federnd gehaltene Rolle (17) in der ersten Kammer geführt ist und die zweite federnd gehaltene Rolle (18) in der zweiten Kammer geführt ist.

9. Kabelspeicherelement (6) zum Einschieben in einen Einschubplatz (2) eines Einschubelements (1) nach einem der Ansprüche 1 und 4 bis 8, umfassend ein längliches, einen quaderförmigen Speicherraum (20) umschließendes Gehäuse (15), wobei im Speicherraum (20) ein Kabel (7) aufgenommen ist, dessen zwei Kabelenden (8,9) über an der Stirnseite (10) des Kabelspeicherelements (6) ausgebildete Öffnungen (21) nach außen geführt und längenveränderlich aus dem Kabelspeicherelement (6) herausziehbar sind, wobei das Kabel (7) im Kabelspeicherelement (6) um wenigstens eine gegen die Kraft eines Federelements (12) verlagerbare, insbesondere an einem Federelement (12) befestigte Rolle (13) geführt ist und im Kabelspeicherelement (6) an dem der verlagerbaren Rolle (13) gegenüberliegenden Ende um ein Umlenkelement (14) herumgeführt ist, wobei das Umlenkelement (14) bevorzugt als feststehendes Element, insbesondere als feststehende Rolle, ausgebildet ist und die beiden Kabelenden (8,9) jeweils unabhängig voneinander gegen eine Federkraft aus dem Kabelspeicherelement (6) herausziehbar sind, wobei die gegen die Kraft des Federelements (12) verlagerbare, insbesondere am Federelement (12) befestigte Rolle (13) wenigstens ein Trennelement (16) aufweist, welches als Trennwand zwischen um die Rolle (13) geführten Kabelabschnitten fungiert und bevorzugt mittig der Rolle (13) angeordnet ist.

10. Kabelspeicherelement (6) zum Einschieben in einen Einschubplatz (2) eines Einschubelements (1) nach einem der Ansprüche 2 bis 8, umfassend ein längliches, einen quaderförmigen Speicherraum (20) umschließendes Gehäuse (15), wobei im Speicherraum (20) ein Kabel (7) aufgenommen ist, dessen erstes Kabelende (8) über eine an der einen Stirnseite (10) des Kabelspeicherelements (6) ausgebildete Öffnung (21) nach außen geführt und längenveränderlich aus dem Kabelspeicherelement (6) herausziehbar ist und dessen zweites Kabelende (22) über eine an der zweiten, gegenüberliegenden Stirnseite (23) des Kabelspeicherelements (6) ausgebildete Öffnung (24) nach außen geführt ist, wobei das Kabel (7) im Kabelspeicherelement (6) um wenigstens eine gegen die Kraft eines Federelements (12) verlagerbare, insbesondere an einem Federelement (12) befestigte Rolle (13) geführt ist und im Kabelspeicherelement (6) an dem der verlagerbaren Rolle (13) gegenüberliegenden Ende um ein Umlenkelement (14) herumgeführt ist, wobei das Umlenkelement (14) bevorzugt als feststehendes Element, insbesondere als feststehende Rolle, ausgebildet ist und die beiden Kabelenden (8,22) jeweils unabhängig voneinander gegen eine Federkraft aus dem Kabelspeicherelement (6) herausziehbar sind, wobei die gegen die Kraft des Federelements (12) verlagerbare, insbesondere am Federelement (12) befestigte Rolle (13) wenigstens ein Trennelement (16) aufweist, welches als Trennwand zwischen um die Rolle (13) geführten Kabelabschnitten fungiert und bevorzugt mittig der Rolle (13) angeordnet ist.

11. Kabelspeicherelement nach Anspruch 10, **dadurch gekennzeichnet, dass** das eine Kabelende (8) unabhängig vom zweiten Kabelende (22) gegen eine Federkraft aus dem Kabelspeicherelement (6) herausziehbar ist.

12. Kabelspeicherelement nach Anspruch 9, 10 oder 11, **dadurch gekennzeichnet, dass** Mittel zum Bremsen der Rückstellbewegung der Rolle (13) vorgesehen sind.

13. Kabelspeicherelement nach einem der Ansprüche 9 bis 12, **dadurch gekennzeichnet, dass** die Rolle (13) schleifend mit der Gehäusewand des Speicherraums (20) des Kabelspeicherelements (6) zusammenwirkt.

14. Kabelspeicherelement nach einem der Ansprüche 9 bis 13, **dadurch gekennzeichnet, dass** das Kabelspeicherelement (6) ein Rollensystem mit mehreren, insbesondere zwei federnd gehaltenen Rollen (17,18) umfasst, wobei bevorzugt zwischen jeweils zwei federnd gehaltenen Rollen (17,18) des Rollensystems eine Trennwand (19) angebracht ist.

15. Kabelspeicherelement nach Anspruch 14, **dadurch gekennzeichnet, dass** die Trennwand (19) den Speicherraum (20) in zwei Kammern unterteilt und die erste federnd gehaltene Rolle (17) in der ersten Kammer geführt ist und die zweite federnd gehaltene Rolle (18) in der zweiten Kammer geführt ist.

## Claims

1. An insert element for frameworks, in particular racks, for use in the information and network technology, comprising a plurality of insertion slots and cable storage elements (6), which are insertable in the insertion slots (2) and received in the insertion slots (2), **characterized in that** in the cable storage elements (6) a cable (7) is each accommodated, the two cable ends (8,9) of which are guided to the outside via openings (21) provided in the end face (10) of the cable storage element (6) and can be pulled out of the cable storage element (6) at variable lengths, wherein the cable (7) in the cable storage element (6) is guided around at least one roller (13) displaceable against the force of a spring element (12) and preferably fastened to the spring element, and on its end located opposite the roller (13) is guided around a deflection element (14), said deflection element (14) being preferably configured as a stationary element, in particular a stationary roller, and wherein the two cable ends (8,9) can each be pulled out of the cable storage element (6) independently of each other against the force of a spring, wherein the roller (13), which is displaceable against the force of the spring element (12) and, in particular, fastened to the spring element (12), comprises at least one partition element (16), which functions as partition wall between the cable portion guided around the roller (13) and is preferably disposed in the middle of the roller (13).

2. An insert element for frameworks, in particular racks, for use in the information and network technology, comprising a plurality of insertion slots and cable storage elements (6), which are insertable in the insertion slots (2) and received in the insertion slots (2), **characterized in that** in the cable storage elements (6) a cable (7) is each accommodated, the first cable end (8) of which is guided to the outside via an opening (21) provided in one end face (10) of the cable storage element (6) and can be pulled out of the cable storage element (6) at variable length and the second cable end (22) of which is guided to the outside via an opening (24) provided in the second, oppositely located end face (23) of the cable storage element (6), wherein the cable (7) in the cable storage element (6) is guided around at least one roller (13) displaceable against the force of a spring element (12) and preferably fastened to the spring element, and on its end located opposite the roller (13) is guided around a deflection element (14), said deflection element (14) being preferably configured as a stationary element, in particular a stationary roller, and wherein the two cable ends (8,9) can each be pulled out of the cable storage element (6) independently of each other against the force of a spring, wherein the roller (13), which is displaceable against the force of the spring element (12) and, in particular, fastened to the spring element (12), comprises at least one partition element (16), which functions as partition wall between the cable portion guided around the roller (13) and is preferably disposed in the middle of the roller (13).

3. An insert element according to claim 2, **characterized in that** the one cable end (8) can be pulled out of the cable storage element (6) independently of the second cable end (22) against the force of a spring.

4. An insert element according to claim 1, 2 or 3, **characterized in that** the cable storage element (6) comprises a housing (15) enclosing a parallelepipedic storage space (20) and the cable (7) is accommodated in the storage space (20).

5. An insert element according to any one of claims 1 to 4, **characterized in that** means for braking the restoring movement of the roller (13) are provided.

6. An insert element according to any one of claims 4 or 5, **characterized in that** the roller (13) slippingly interacts with the housing wall (15) of the storage space (20) of the cable storage element (6).

7. An insert element according to any one of claims 1 to 6, **characterized in that** the cable storage element (6) comprises a roller system with several, in particular two, resiliently held rollers (17,18), wherein preferably a partition wall (19) is each provided between two resiliently held rollers (17,18) of the roller system.

8. An insert element according to claim 7, **characterized in that** the partition wall (19) subdivides the storage space (20) into two chambers, and the first resiliently held roller (17) is guided in the first chamber and the second resiliently held roller (18) is guided in the second chamber.

9. A cable storage element (6) for insertion into an insertion slot (2) of an insert element (1) according to any one of claims 1 and 4 to 8, comprising an elongate housing (15) defining a parallelepipedic storage space (20), wherein a cable (7) is accommodated in the storage space (20), the two cable ends (8,9) of which are guided to the outside via openings (21) provided in the end face (10) of the cable storage element (6) and can be pulled out of the cable storage element (6) at variable lengths, wherein the cable (7) in the cable storage element (6) is guided around at least one roller (13) displaceable against the force of a spring element (12) and preferably fastened to the spring element, and, in the cable storage element (6), on its end located opposite the roller (13) is guided around a deflection element (14), said deflection element (14) being preferably configured as a stationary element, in particular a stationary roller, and wherein the two cable ends (8,9) can each be pulled out of the cable storage element (6) independently of each other against the force of a spring, wherein the roller (13), which is displaceable against the force of the spring element (12) and, in particular, fastened to the spring element (12), comprises at least one partition element (16), which functions as partition wall between the cable portion guided around the roller (13) and is preferably disposed in the middle of the roller (13).

10. A cable storage element (6) for insertion into an insertion slot (2) of an insert element (1) according to any one of claims 2 to 8, comprising an elongate housing (15) defining a parallelepipedic storage space (20), wherein a cable (7) is accommodated in the storage space (20), the first cable end (8) of which is guided to the outside via an opening (21) provided in one end face (10) of the cable storage element (6) and can be pulled out of the cable storage element (6) at variable length, and the second cable end (22) of which is guided to the outside via an opening (24) provided in the second, oppositely located end face (23) of the cable storage element (6), wherein the cable (7) in the cable storage element (6) is guided around at least one roller (13) displaceable against the force of a spring element (12) and preferably fastened to the spring element, and, in the cable storage element (6), on its end located opposite the roller (13) is guided around a deflection element (14), said deflection element (14) being preferably configured as a stationary element, in particular a stationary roller, and wherein the two cable ends (8,9) can each be pulled out of the cable storage element (6) independently of each other against the force of a spring, wherein the roller (13), which is displaceable against the force of the spring element (12) and, in particular, fastened to the spring element (12), comprises at least one partition element (16), which functions as partition wall between the cable portion guided around the roller (13) and is preferably disposed in the middle of the roller (13).

11. A cable storage element according to claim 10, **characterized in that** one cable end (8) can be pulled out of the cable storage element (6) independently of the second cable end (22) against the force of a spring.

12. A cable storage element according to any one of claims 9, 10 or 11, **characterized in that** means for braking the restoring movement of the roller (13) are provided.

13. A cable storage element according to any one of claims 9 to 12, **characterized in that** the roller (13) slippingly interacts with the housing wall (15) of the storage space (20) of the cable storage element (6).

14. A cable storage element according to any one of claims 9 to 13, **characterized in that** the cable storage element (6) comprises a roller system with several, in particular two, resiliently held rollers (17,18), wherein preferably a partition wall (19) is each provided between two resiliently held rollers (17,18) of the roller system.

15. A cable storage element according to claim 14, **characterized in that** the partition wall (19) subdivides the storage space (20) into two chambers, and the first resiliently held roller (17) is guided in the first chamber and the second resiliently held roller (18) is guided in the second chamber.

## Revendications

1. Élément d'insertion pour baies, en particulier pour racks, pour une utilisation dans la technologie de l'information et des réseaux, comprenant une pluralité d'emplacements d'insertion et d'éléments range-câble (6) pouvant être insérés dans les emplacements d'insertion (2), qui sont reçus dans les emplacements d'insertion (2), **caractérisé en ce que**, dans les éléments range-câble (6), respectivement un câble (7) est reçu, dont les deux extrémités de câble (8,9) sont amenées vers l'extérieur via des ouvertures (21) réalisées sur la face frontale (10) de l'élément range-câble (6) et peuvent être retirées de l'élément range-câble (6) sur une longueur variable, dans lequel le câble (7) est guidé dans l'élément range-câble (6) autour d'au moins un rouleau (13) pouvant être déplacé contre la force d'un élément à ressort (12), de préférence fixé à l'élément à ressort, et est guidé autour d'un élément de renvoi (14) à l'extrémité opposée au rouleau (13), dans lequel l'élément de renvoi (14) est de préférence réalisé comme un élément fixe, en particulier comme un rouleau fixe, et les deux extrémités de câble (8,9) peuvent être retirées de l'élément range-câble (6) respectivement indépendamment l'une de l'autre contre une force de ressort, dans lequel le rouleau (13) pouvant être déplacé contre la force de l'élément à ressort (12), en particulier fixé à l'élément à ressort (12) présente au moins un élément de séparation (16), qui fonctionne comme une paroi de séparation entre les sections de câble guidées autour du rouleau (13) et est agencé de préférence au centre du rouleau (13).

2. Élément d'insertion pour baies, en particulier pour racks, pour une utilisation dans la technologie de l'information et des réseaux, comprenant une pluralité d'emplacements d'insertion et d'éléments range-câble (6) pouvant être insérés dans les emplacements d'insertion (2), qui sont reçus dans les emplacements d'insertion (2), **caractérisé en ce que**, dans les éléments range-câble (6), respectivement un câble (7) est reçu, dont la première extrémité de câble (8) est amenée vers l'extérieur via une ouverture (21) réalisée sur la face frontale (10) de l'élément range-câble (6) et peut être retirée de l'élément range-câble (6) sur une longueur variable, et dont la seconde extrémité de câble (22) est amenée vers l'extérieur via une ouverture (24) réalisée sur la seconde face frontale (23) opposée de l'élément range-câble (6), dans lequel le câble (7) est guidé dans l'élément range-câble (6) autour d'au moins un rouleau (13) pouvant être déplacé contre la force d'un élément à ressort (12), de préférence fixé à l'élément à ressort, et est guidé autour d'un élément de renvoi (14) à l'extrémité opposée au rouleau (13), dans lequel l'élément de renvoi (14) est de préférence réalisé comme un élément fixe, en particulier comme un rouleau fixe, et les deux extrémités de câble (8, 22) peuvent être retirées de l'élément range-câble (6) respectivement indépendamment l'une de l'autre contre une force de ressort, dans lequel le rouleau (13) pouvant être déplacé contre la force de l'élément à ressort (12), en particulier fixé à l'élément à ressort (12), présente au moins un élément de séparation (16), qui fonctionne comme une paroi de séparation entre les sections de câble guidées autour du rouleau (13) et est agencé de préférence au centre du rouleau (13).

3. Élément d'insertion selon la revendication 2, **caractérisé en ce qu'**une extrémité de câble (8) peut être retirée de l'élément range-câble (6) contre une force de ressort indépendamment de la seconde extrémité de câble (22).

4. Élément d'insertion selon la revendication 1, 2 ou 3, **caractérisé en ce que** l'élément range-câble (6) comprend un boîtier (15) renfermant un espace de stockage parallélépipédique (20) et le câble (7) est reçu dans l'espace de stockage (20).

5. Élément d'insertion selon l'une quelconque des revendications 1 à 4, **caractérisé en ce que** des moyens sont prévus pour freiner un mouvement de retour du rouleau (13).

6. Élément d'insertion selon la revendication 4 ou 5, **caractérisé en ce que** le rouleau (13) coopère de manière coulissante avec une paroi de boîtier de l'espace de stockage (20) de l'élément range-câble (6).

7. Élément d'insertion selon l'une quelconque des revendications 1 à 6, **caractérisé en ce que** l'élément range-câble (6) comprend un système de rouleaux avec plusieurs, en particulier deux rouleaux (17, 18) maintenus élastiquement, dans lequel une paroi (19) est de préférence placée entre respectivement deux rouleaux (17, 18) maintenus élastiquement du système de rouleaux.

8. Élément d'insertion selon la revendication 7, **caractérisé en ce que** la paroi de séparation (19) divise l'espace de stockage (20) en deux chambres et le premier rouleau (17) maintenu élastiquement est guidé dans la première chambre et le second rouleau (18) maintenu élastiquement est guidé dans la seconde chambre.

9. Élément range-câble (6) destiné à être inséré dans un emplacement d'insertion (2) d'un élément d'insertion (1) selon l'une quelconque des revendications 1 et 4 à 8, comprenant un boîtier allongé (15) renfermant un espace de stockage parallélépipédique (20), dans lequel un câble (7) est reçu dans l'espace de stockage (20), dont les deux extrémités de câble (8,9) sont guidées vers l'extérieur via des ouvertures (21) réalisées sur la face frontale (10) de l'élément range-câble (6) et peuvent être retirées de l'élément range-câble (6) sur une longueur variable, dans lequel le câble (7) est guidé dans l'élément range-câble (6) autour d'au moins un rouleau (13) pouvant être déplacé contre la force d'un élément à ressort (12), en particulier fixé à l'élément à ressort (12), et est guidé autour d'un élément de renvoi (14) à l'extrémité opposée au rouleau (13), dans lequel l'élément de renvoi (14) est de préférence réalisé comme un élément fixe, en particulier comme un rouleau fixe, et les deux extrémités de câble (8,9) peuvent être retirées de l'élément range-câble (6) respectivement indépendamment l'une de l'autre contre une force de ressort, dans lequel le rouleau (13) pouvant être déplacé contre la force de l'élément à ressort (12), en particulier fixé à l'élément à ressort (12) présente au moins un élément de séparation (16) qui fonctionne comme une paroi entre les sections de câble guidées autour du rouleau (13) et qui est agencé de préférence au centre du rouleau (13).

10. Élément range-câble (6) destiné à être inséré dans un emplacement d'insertion (2) d'un élément d'insertion (1) selon l'une quelconque des revendications 2 à 8, comprenant un boîtier allongé (15) renfermant un espace de stockage parallélépipédique (20), dans lequel un câble (7) est reçu dans l'espace de stockage (20), dont la première extrémité de câble (8) est guidée vers l'extérieur via une ouverture (21) réalisée sur une face frontale (10) de l'élément range-câble (6) et peut être retirée de l'élément range-câble (6) sur une longueur variable et dont la seconde extrémité de câble (22) peut être guidée vers l'extérieur via une ouverture (24) réalisée sur la seconde face frontale (23) opposée de l'élément range-câble (6), dans lequel le câble (7) est guidé dans l'élément de stockage de câble (6) autour d'au moins un rouleau (13) pouvant être déplacé contre la force d'un élément à ressort (12), en particulier fixé à un élément à ressort (12), et est guidé dans l'élément range-câble (6) autour d'un élément de renvoi (14) à l'extrémité opposée au rouleau (13) pouvant être déplacé, dans lequel l'élément de renvoi (14) est de préférence réalisé comme un élément fixe, de préférence comme un rouleau fixe, et les deux extrémités de câble (8, 22) peuvent être retirées respectivement indépendamment l'une de l'autre de l'élément range-câble (6) contre une force de ressort, dans lequel le rouleau (13) pouvant être déplacé contre la force de l'élément à ressort (12),en particulier fixé à l'élément à ressort (12) présente au moins un élément de séparation (16) qui fonctionne comme une séparation entre les sections de câble guidées autour du rouleau (13) et est agencé de préférence au centre du rouleau (13).

11. Élément range-câble selon la revendication 10, **caractérisé en ce qu'**une extrémité de câble (8) peut être retirée de l'élément range-câble (6) contre une force de ressort indépendamment de la seconde extrémité de câble (22).

12. Élément range-câble selon la revendication 9, 10 ou 11, **caractérisé en ce que** des moyens sont prévus pour freiner le mouvement de retour du rouleau (13).

13. Élément range-câble selon l'une quelconque des revendications 9 à 12, **caractérisé en ce que** le rouleau (13) coopère de manière coulissante avec la paroi de boîtier de l'espace de stockage (20) de l'élément range-câble (6).

14. Élément range-câble selon l'une quelconque des revendications 9 à 13, **caractérisé en ce que** l'élément range-câble (6) comprend un système de rouleaux avec plusieurs, en particulier deux rouleaux (17, 18) maintenus élastiquement, dans lequel une paroi (19) est de préférence placée entre respectivement deux rouleaux (17, 18) maintenus élastiquement du système de rouleaux.

15. Élément range-câble selon la revendication 14, **caractérisé en ce que** la paroi de séparation (19) divise l'espace de stockage (20) en deux chambres et le premier rouleau (17) maintenu élastiquement est guidé dans la première chambre et le second rouleau (18) maintenu élastiquement est guidé dans la seconde chambre.
